# EUROPEAN PATENT SPECIFICATION

(11) **EP 0 298 496 B1**
(45) Date of publication and mention of the grant of the patent: **05.10.1994**
(21) Application number: 88110940.9
(22) Date of filing: 08.07.1988
(51) Int. Cl.: H01L 21/68, H01L 21/66

(54) **Adhesive tape for bonding chips thereon**
Klebestreifen für das Festhalten von Chips darauf
Bande adhésive pour y fixer des puces

(30) Priority: 09.07.1987 JP 171616/87; 09.07.1987 JP 171617/87; 09.07.1987 JP 171618/87; 09.07.1987 JP 171619/87; 14.07.1987 JP 175649/87
(43) Date of publication of application: 11.01.1989
(73) Proprietor: SUMITOMO ELECTRIC INDUSTRIES LIMITED, Osaka-shi, Osaka 541 (JP)
(72) Inventor: Nishiguchi, Masanori c/o Yokohama Works of, Sakae-ku Yokohama-shi Kanagawa (JP); Fujihira, Mitsuaki c/o Yokohama Works of, Sakae-ku Yokohama-shi Kanagawa (JP)
(74) Representative: Füchsle, Klaus, Dipl.-Ing.

(56) References cited:
- EP-A- 0 066 694
- EP-A- 0 150 882
- GB-A- 2 056 766

## Description

### BACKGROUND OF THE INVENTION

### Field of the Invention

The present invention generally relates to an adhesive tape suited for use with a chip mounting apparatus for mounting a chip, for example, a semiconductor chip on a package or on a lead frame, and more particularly, for use with a chip mounting apparatus employing therein an adhesive tape for transporting a large number of chips bonded thereon to a desired position.

### Description of the Prior Art

Chips, for example, semiconductor chips, chip capacitors, chip resistors are generally successively transported from one location to another while bonded on an adhesive tape during the manufacturing process. Accordingly, when such chips are each mounted on a package or a lead frame, it is necessary to pick them up one by one from the tape. Vacuum pickup method is generally employed for this purpose, since a circuit, or electrodes formed on the surface of each chip are required to be kept out of contact with any hard member or substance.

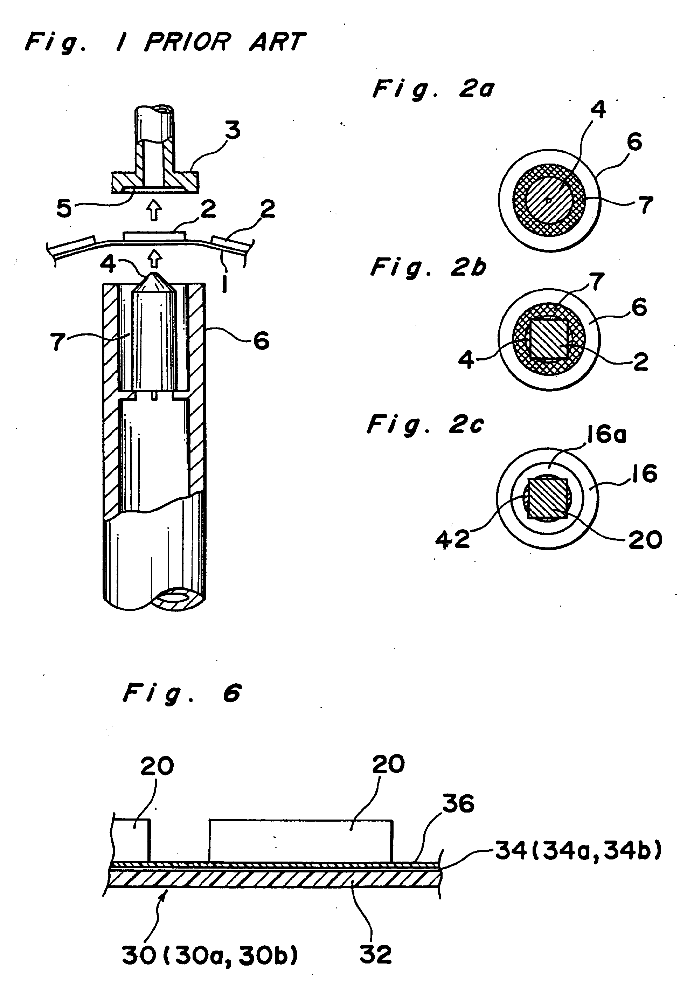

Fig. 1 illustrates the main portion of a conventional chip mounting apparatus employing therein the vacuum pickup method.

As shown in Fig. 1, a plurality of chips 2 are bonded on an adhesive tape 1 to be supplied between a vacuum pickup collet 3 and a push rod 4. The collet 3 has at its lower surface a suction port 5 which is as same in configuration and size as the chip 2 and communicates with a vacuum means (not shown) such as a vacuum pump. The push rod 4 has a coned top and is secured inside a hollowed cylindrical stage 6.

In such an apparatus, when one of the chips 2 bonded on the tape 1 is positioned between the push rod 4 and the collet 3, the push rod 4, together with the stage 6, is caused to move upwards to push the tape 1 from below. The chip 2 is then drawn to the suction port 5 of the collet 3 to be picked up thereby.

In the vacuum pickup of the chip 2, however, it is necessary to match the center of the chip 2 and the tip of the push rod 4. When the position of the former deviates from that of the latter, the chip 2 is not properly picked up at times. As a result, the chip 2 inclines or drops off the collet 3 to be subjected to any undesirable damage. Because of this, the conventional apparatus is provided with a monitor means (not shown) for monitoring the chip 2 with respect to the stage 6 for the proper positioning thereof.

The positioning of the collet 3 and the push rod 4 is executed prior to the supply of the tape 1. In this event, the monitor means recognizes a pattern as shown in Fig. 2a. Then, the tape 1 having thereon a plurality of chips 2 is supplied above the push rod 4 so that one of the chips 2 may be accurately positioned with respect to the stage 6 by the pattern recognition. In this method, the positioning between the tip of the push rod 4 and the chip 2 is executed by way of the stage 6. After the positioning, the chip 2 is pushed upwards by the push rod 4 to enable the chip to be picked up by the collet 3.

However, the conventional chip mounting apparatus is disadvantageous in that the accurate positioning can not be readily executed. More specifically, when the chip 2 i.e. an object of the positioning has a small reflectance, a clear pattern of the chip 2 can not be recognized in contrast with that of the stage 6, thus resulting in insufficient pattern recognition. In other words, as shown in Fig. 1, the stage 6 has an open upper end portion through which the push rod 4 is inserted into a hollow portion 7 of the stage 6. In the pattern recognition by the monitor means, the sufficient contrast can not be obtained due to the fact that the brightness of the pattern of the hollow portion 7 is not so different from that of the chip 2, as shown in Fig. 2b.

Meanwhile, in the manufacture of a semiconductor device such as an IC (Integrated Circuit), a large number of semiconductor elements are initially formed into a certain pattern on a semiconductor wafer. These semiconductor elements are then individually separated from one another and each of the separated elements is mounted on a package or on a lead frame through die-bonding by brazing or other means. During the separation, the semiconductor wafer is cut into individual semiconductor chips by dicing, by dicing and breaking or by scribing and breaking. In consideration of the workability in the next die-bonding process, the semiconductor wafer is cut into small squares in a state such that the semiconductor wafer is bonded on an adhesive tape. The semiconductor chips are then separated individually from one another by extending the tape. On the other hand, during the die-bonding process, the semiconductor chips separated individually on the tape are picked up one by one to be transported onto the package or lead frame.

However, the conventional adhesive tape 1 has the property of reflecting light. Because of this, when the monitor means detects light reflected from the tape 1, it becomes difficult to distinguish a contour line of the chip 2 from the tape 1. As a result, since the clear pattern recognition of the chip 2 can not be achieved, the accurate positioning of the chip 2 becomes disadvantageously difficult.

A prior art document that is of interest is EP-A-0 150 882 that discloses a support tape with a pattern of adhesive of a size and shape to support at least one semiconductor chip thereon. Individual chips are each positioned over a corresponding adhesive support and contacted therewith. After contact between chip and support film/adhesive has been made, the chip is removed from the film with its adherent adhesive support attached. This chip/adhesive composite can then be placed into a suitable chip carrier and cured in an appropriate fashion. Afterwards, wires can be bonded to the chip as conventionally performed. This prior art suffers from the drawback that when the means used to remove a chip from the film relies on light means for detecting where the chip is, a clear recognition of the chip is not necessarily achieved.

### SUMMARY OF THE INVENTION

The present invention is as defined in the accompanying claims in which Claim 1 has been divided into a two-part form wherein the preamble of claim 1 corresponds to EP-A-0 150 882, based on the assumption that EP-A-0 150 882 is the nearest state of the art.

The present invention has been developed with a view to substantially eliminating the above described disadvantage inherent in the prior art adhesive tape for bonding thereon a plurality of chips, and has for its essential object to provide an improved adhesive tape which makes it possible to readily achieve clear pattern recognition of each chip.

Another important object of the present invention is to provide an adhesive tape of the above described type which is simple in construction and can be readily manufactured at a low cost.

In accomplishing these and other objects, the adhesive tape according to one preferred embodiment of the present invention consists of at least three layers: a base layer; a film laminated on at least one surface of the base layer and having a reflectance with respect to light applied thereto different from that of the chip; and an adhesive layer laminated either on of said base layer or on said film to bond the chip thereon.

### BRIEF DESCRIPTION OF THE DRAWINGS

These and other objects and features of the present invention will become more apparent from the following description taken in conjunction with the preferred embodiment thereof with reference to the accompanying drawings, throughout which like parts are designated by like reference numerals, and wherein;
Fig. 1 is a fragmentary side elevational view, partly in section, of the main portion of a conventional chip mounting apparatus;
Figs. 2a to 2c are views showing several patterns during the positioning of the chip;
Fig. 3 is a perspective view of a chip mounting apparatus being used with the tape of the present invention;
Fig. 4 is a fragmentary side elevational view, partly in section, of the main portion of the chip mounting apparatus of Fig. 3;
Fig. 5 is a view similar to Fig. 1;
Fig. 6 is a sectional view of an adhesive tape, on which a plurality of chips are bonded, according to one preferred embodiment of the present invention; and
Fig. 7 is a view similar to Fig. 6, which particularly shows a modification of the adhesive tape.

### DETAILED DESCRIPTION OF THE PREFERRED EMBODIMENTS

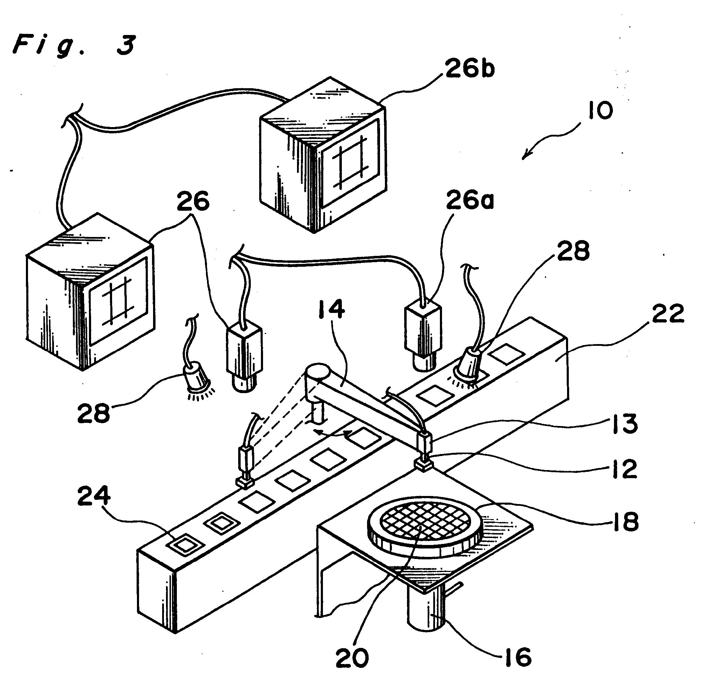

Referring first to Fig. 3, a chip mounting apparatus, generally shown by 10, comprises a vacuum pickup collet 12, a collet holder 13 for securely holding the collet 12, a holder arm 14 having one end rigidly secured to the collet holder 13 and the other end coupled with a driving means (not shown), a movable hollowed cylindrical stage 16 located below a wafer ring 18 on which a large number of individually separated semiconductor chips 20 are placed, a work transport device 22 for transporting packages 24 or lead frames placed thereon, a monitor means 26 for monitoring the position of each semiconductor chip 20 held by the collet 12 with respect to the stage 16 and to the package 24, and a lighting system 28 for applying light to the semiconductor chip 20. The holder arm 14 is, for example, of a robot hand for driving the collet holder 13 in three-dimensional directions. The monitor means 26 is comprised of two sets of a monitor camera 26a and a display 26b respectively for detecting and for displaying the position of the semiconductor chip 20 with respect to the stage 16 and to the package 24. The lighting system 28 includes two lamps for applying light to the chip 20. One of the lamps 28 is located in the vicinity of one monitor camera 26a and above the wafer ring 18 so as to apply the light to one of the chips 20 placed on the wafer ring 18. The other lamp 28 is located in the vicinity of the other monitor camera 26a and above the work transport device 22 so as to apply the light to the chip 20 which has been picked up by the collet 12 from the wafer ring 18 and is about to be attached onto one of the packages 24 placed on the work transport device 22. Accordingly, the collet 12 is free to move in three-dimensional directions between a location where one of the chips 20 is picked up from the wafer ring 18 and another location where this chip 20 is attached onto the package 24.

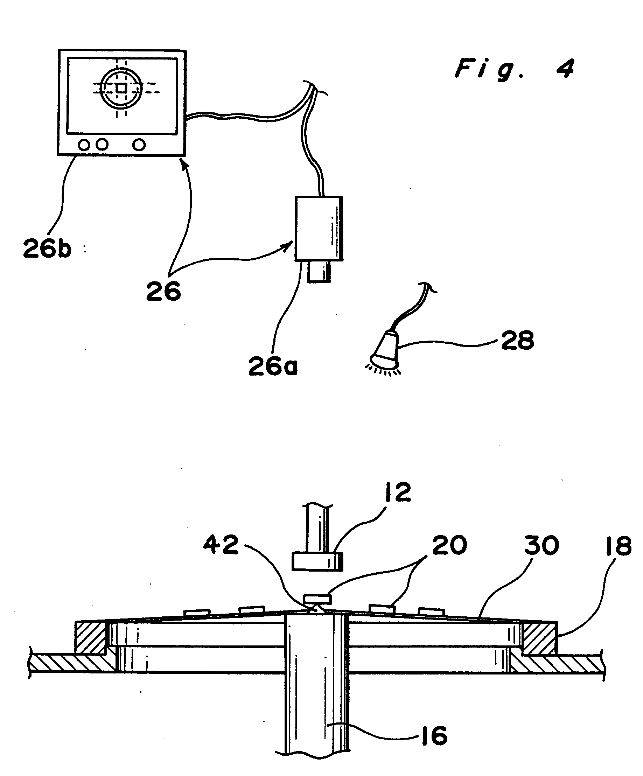

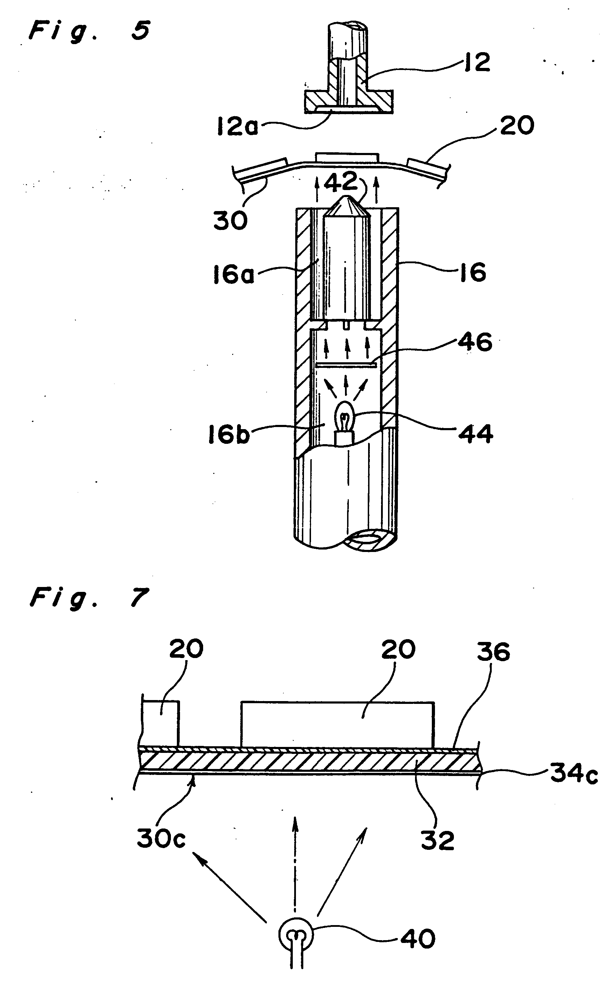

As shown in Figs. 4 and 5, a plurality of semiconductor chips 20 placed on the wafer ring 18 are caused to adhere to an adhesive sheet or tape 30 for bonding the chips 20 thereon.

When one of the chips 20 is removed from the tape 30 onto one of the packages 24, the collet 12 and a push rod 42 are located above and below the chip 20, respectively. The collet 12 communicates with a certain vacuum means (not shown) and has at its lower surface a suction port 12a to enable the chip 20 to be picked up by drawing the vacuum through said port. The push rod 42 has a coned top and is inserted from above into a first recess 16a formed in an upper portion of the stage 16. The push rod 42 is rigidly secured at its proper position inside the stage 16 through suitable engagement between the two. The stage 16 is free to move both in horizontal and vertical directions. Upon upward movement of the stage 16 together with the push rod 42, the chip 20 is pushed up by the push rod 42 towards the suction port 12a of the collet 12.

The stage 16 is further provided with a second recess 16b communicating the first recess 16a in which the push rod 42 is rigidly secured. The second recess 16b accommodates a light source 44 such as a lamp, for example an LED (Light Emitting Diode). An optical plate 46 is securely supported above the light source 44 in the second recess 16b by way of poles (not shown). Accordingly, when the light source 44 is supplied with electric power, it emits light from the upper portion of the stage 16 through the second and first recesses 16b and 16a. In this event, the optical plate 46 glows white by receiving light from the light source 44. The light is then enters the monitor camera 26a of the monitor means 26 to project the chip 20 on the display 26b.

The operation of the chip mounting apparatus 10 will be explained hereinafter.

The positioning of the push rod 42 can be readily executed by moving the stage 16 and by projecting a pattern of the push rod 42 on the display 26b, since the push rod 42 is properly positioned inside the stage 16.

In subsequent positioning of the chip 20, the chip 20 is supplied between the collet 12 and the push rod 42 in a state in which the chip 20 is bonded on the adhesive tape 30. During the positioning, the light source 44 emits light through the first recess 16a of the stage 16 so that the monitor means 26 can detect the light. As a result, the pattern of the first recess 16a becomes bright, as shown in Fig. 2c, whereas that of the chip 20 having a small reflectance is still dark. The clear contrast between the patterns of the first recess 16a and the chip 20 can facilitate the accurate positioning of the chip 20. Accordingly, since the tip of the push rod 42 and the center of the chip 20 coincide with each other, the chip 20 can be properly picked up by the collet 12.

It is to be noted here that the light source 44 may be arranged outside the stage 16 and light emitted therefrom may be introduced inside the stage 16 by way of a light guide means such as an optical fiber.

It is also to be noted that the optical plate 46 may be removed from the stage 16.

It is further to be noted that in this embodiment, although the push rod 42 is rigidly secured inside the stage 16, the former may be arranged vertically movably inside the latter. In this case, upon upward movement of the push rod 42 within the stage 16, the collet 12 can adsorb the chip 20.

Figs. 6 and 7 each depict the constitution of the adhesive tape of the present invention. The clear pattern recognition can be also achieved by the conventional chip mounting apparatus of Fig. 1 employing therein the adhesive tape of the present invention.

As shown in Fig. 6, the tape 30 according to one preferred embodiment of the present invention consists of a base layer 32 of extendable soft plastic, for example vinyl having a predetermined thickness, an anti-reflection film 34 laminated on the base layer 32 and an adhesive layer 36 laminated on the anti-reflection film 34. The tape 30 initially wound around a supply roll (not shown) is cut into squares each of a configuration having a size greater than the diameter of the semiconductor wafer. The tape 30 is then transferred to the dicing process in a state in which the semiconductor wafer is bonded on the adhesive layer 36. After the dicing, the tape 30 is extended so that the semiconductor wafer bonded thereon is separated into small squares each of a semiconductor chip 20. An adhesive primer in plastic group is preferably used as the adhesive layer 36.

The anti-reflection film 34 is so constituted as not to reflect light and is interposed between the base layer 32 and the adhesive layer 36. The anti-reflection film 34 can be formed, for example, by coating a film having a thickness in accordance with the wavelength of light to be applied. However, since the tape 30 is extended after the dicing, it is necessary to adjust the thickness of the film to be coated in accordance with an extension ratio. Furthermore, black or gray plastic can be also used for the anti-reflection film 34. This colored plastic can be readily obtained by putting black pigment in the plastic. The anti-reflection film 34 can be readily laminated on the base layer 32 by coating or spraying the plastic or by soaking the base layer 32 into the molten plastic. Other material having light absorbing properties can be used as the anti-reflection film 34.

The tape 30 having therein the anti-reflection film 34 and obtained in the above described manner can be used as it is, in the ordinary manufacturing process of the semiconductor chips 20. In the vacuum pickup apparatus for picking up individual semiconductor chips 20 one at a time, light is applied to one of the semiconductor chips 20 bonded on the tape 30 for its proper positioning. The light applied to the semiconductor chip 20 is reflected on the surface thereof whereas the light applied to the tape 30 is prevented, by the anti-reflection film 34, from reflecting thereon. Accordingly, since the monitor means 26 detects only the light reflected on the chip 20, it can clearly catch the contour of the chip 20, and therefore, the positioning of the chip 20 by the pattern recognition can be accurately and readily achieved.

The anti-reflection film 34 of Fig. 6 may be replaced by a light diffusion film 34a. The light diffusion film 34a interposed between the base layer 32 and the adhesive layer 36 is so constituted as to diffuse the light. To this end, for example, soft plastic having the property of diffusing the light to be applied can be used for the light diffusion film 34a. Such a light diffusion film 34a can be readily obtained by putting fine particles into the plastic. The light diffusion film 34a can be laminated on the base layer 32 by coating or spraying the plastic or by soaking the base layer 32 into the molten plastic.

When the tape 30a is formed as described above, light applied thereto is diffused by the light diffusion film 34a in all directions. Accordingly, the monitor means 26 detects the light reflected on the chip 20 far greater than that from the tape 30 and can therefore clearly monitor the contour of the chip 20.

Furthermore, the anti-reflection film 34 of Fig. 6 may be replaced by a reflection film 34b. The reflection film 34b interposed between the base layer 32 and the adhesive layer 36 is so constituted as to reflect the majority of light. The reflection film 34b can be formed, for example, by coating on the base layer 32 a film having a reflection ratio in accordance with the wavelength of light to be applied. A metal such as aluminum can be used for the reflection film 34b. The reflection film 34b can be readily formed on the base layer 32 by coating or spraying the reflection material or through vacuum evaporation.

Light applied to the chip 20 bonded on the tape 30b partly reflects on the surface of the chip 20 whereas light applied to the tape 30b is mostly reflected by the reflection film 34b. Accordingly, the monitor means 26 detects the reflected light from the tape 30b far greater than that from the chip 20. Thus, the clear recognition of the contour of the chip 20 can facilitate the correct positioning thereof.

Fig. 7 depicts a modification of the adhesive tape of the present invention.

As shown in Fig. 7, the tape 30c consists of the extendable base layer 32, the adhesive layer 36 laminated on one surface of the base layer 32 and a light scattering film 34c for scattering light applied thereto laminated on the other surface of the base layer 32. The light scattering film 34c can be formed, for example, by coating on the base layer 32 a film containing fine particles of alumina and transparent fine particles. More specifically, the light scattering film 34c can be readily laminated on the base layer 32 by coating or spraying the aforementioned material for scattering or by soaking the base layer 32 into the molten plastic containing this material.

Unlike the above described chip fastening tape 30, 30a or 30b, an additional light source 40 is required to locate below the tape 30c to emit light towards a lower surface thereof. The light scattering film 34c scatters light applied to the tape 30c. Accordingly, only the scattered light from portions of the tape 30c having thereon no chip can enter the monitor means 26 and clearly silhouettes the chip 20, thus facilitating the accurate positioning thereof by the pattern recognition.

## Claims

1. An adhesive tape (30, 30a, 30b, 30c) suited for use with a chip mounting apparatus (10) in which light is applied to one of a plurality of chips (20) bonded on said tape to detect the position of said chip, said tape having a base layer (32) and an adhesive layer (36) bonding a plurality of chips (20) to said tape;
**characterized** by said tape having
a film (34) laminated on at least one surface of said base layer (32) and having a reflectance with respect to light applied thereto different from the reflectance of said chip (20); and that
said adhesive layer (36) is laminated either on said base layer (32) or on said film (34).

2. The tape of Claim 1, wherein said film (34) is an anti-reflection film interposed between said base layer (32) and said adhesive layer (3c).

3. The tape of Claim 1, wherein said film (34) is a light diffusion film (34a) interposed between said base layer (32) and said adhesive layer (36).

4. The tape of Claim 1, wherein said film (34) is a light reflection film (34b) interposed between said base layer (32) and said adhesive layer (36).

5. The tape of Claim 1, wherein said film (34) is a light scattering film (34c) formed on one surface of said base layer (32) of which said adhesive layer (36) is formed on the other surface.

## Patentansprüche

1. Klebeband (30, 30a, 30b, 30c), geeignet zur Verwendung mit einer Chip-Montagevorrichtung (10), in der Licht auf einen von einer Mehrzahl von Chips (20) geworfen wird, die auf dem besagten Band aufgeklebt sind, um die Position des besagten Chips zu erfassen, wobei das besagte Band eine Trägerschicht (32) und eine Klebeschicht (36) aufweist, die eine Mehrzahl von Chips (20) mit dem besagten Band verbindet;
dadurch gekennzeichnet, daß das besagte Band aufweist:
einen Film (34), der auf mindestens eine Oberfläche der besagten Trägerschicht (32) auflaminiert ist und in Bezug auf Licht, das darauf geworfen wird, ein vom Reflexionsvermögen des besagten Chips (20) verschiedenes Reflexionsvermögen aufweist; und daß
die besagte Klebeschicht (36) entweder auf die besagte Trägerschicht (32) oder auf den besagten Film (34) auflaminiert ist.

2. Band nach Anspruch 1, dadurch gekennzeichnet, daß der besagte Film (34) ein zwischen die besagte Trägerschicht (32) und die besagte Klebeschicht (36) eingefügter Antireflexionsfilm ist.

3. Band nach Anspruch 1, dadurch gekennzeichnet, daß der besagte Film ein zwischen die besagte Trägerschicht (32) und die besagte Klebeschicht (36) eingefügter Lichtdiffusionsfilm (34a) ist.

4. Band nach Anspruch 1, dadurch gekennzeichnet, daß der besagte Film (34) ein zwischen die besagte Trägerschicht (32) und die besagte Klebeschicht (36) eingefügter Lichtreflexionsfilm (34b) ist.

5. Band nach Anspruch 1, dadurch gekennzeichnet, daß der besagte Film (34) ein Lichtstreuungsfilm (34c) ist, der auf einer Oberfläche der besagten Trägerschicht (32) ausgebildet ist, von der die besagte Klebeschicht (36) auf der anderen Oberfläche ausgebildet ist.

## Revendications

1. Ruban adhésif (30, 30a, 30b, 30c) convenant pour emploi avec un appareil (10) de montage de puce dans lequel on envoie de la lumière sur l'une d'une pluralité de puces (20) liées sur ledit ruban pour détecter la position de ladite puce, ledit ruban comportant une couche de base (32) et une couche d'adhésif (36) liant sur ledit ruban une pluralité de puces (20);
caractérisé par le fait que ledit ruban comporte
un film (34) lamifié sur au moins l'une des surfaces de ladite couche de base (32) et présentant un coefficient de réflexion en rapport avec la lumière qui lui est envoyée et différent du coefficient de réflexion de ladite puce (20); et par le fait que
ladite couche d'adhésif (36) est lamifiée soit sur ladite couche de base (32) soit sur ledit film (34).

2. Le ruban de la revendication 1 dans lequel ledit film (34) est un film anti-réfléchissant interposé entre ladite couche de base (32) et ladite couche d'adhésif (36).

3. Le ruban de la revendication 1, dans lequel ledit film (34) est un film (34a) de diffusion de la lumière interposé entre ladite couche de base (32) et ladite couche d'adhésif (36).

4. Le ruban de la revendication 1, dans lequel ledit film (34) est un film (34b) réfléchissant la lumière interposé entre ladite couche de base (32) et ladite couche d'adhésif (36).

5. Le ruban de la revendication 1, dans lequel ledit film (34) est un film (34c) de diffusion de la lumière formé sur l'une des surfaces de ladite couche de base (32) sur l'autre surface de laquelle est formée ladite couche d'adhésif (36).
